# DEMANDE DE BREVET EUROPEEN

(11) **EP 3 128 670 A1**
(43) Date de publication de la demande: **08.02.2017**
(21) Numéro de dépôt: 16181192.2
(22) Date de dépôt: 26.07.2016
(51) Int. Cl.: H02S 40/34, H01L 51/42

(54) **PROCEDE DE RACCORDEMENT D'UN DISPOSITIF ELECTRONIQUE FLEXIBLE A UN FIL ELECTRIQUE**

(30) Priorité: 06.08.2015 FR 1557590
(71) Demandeur: Armor, 44100 Nantes (FR)
(72) Inventeur: CHARRIER, Nicolas, 44200 NANTES (FR); RIVIERE, Guillaume, 44400 REZE (FR)
(74) Mandataire: Lavoix

(57) **Abrégé**

L'invention concerne un procédé de raccordement d'un dispositif électronique organique flexible à un fil électrique (2), le procédé comportant les étapes de :
- fourniture d'un dispositif électronique flexible,
- fourniture d'un fil électrique (2),
- fourniture d'un organe de contact (3) comportant au moins un élément conducteur (30) comprenant une face de contact (321), la face de contact (321) définissant une surface de contact,
- incision du film barrière d'encapsulation définissant une surface d'incision présentant une dimension maximale et une dimension minimale, la dimension maximale de la surface d'incision étant strictement inférieure à la dimension maximale de la surface de contact, et
- assemblage de l'élément conducteur (30) et de la bande conductrice (1) à travers l'incision pour assurer une conduction électronique entre l'élément conducteur (30) et l'électrode.

## Description

La présente invention concerne un procédé de raccordement d'un dispositif électronique organique flexible à un fil électrique. La présente invention concerne également un dispositif électronique organique flexible.

Les dispositifs organiques flexibles sont des empilements de type conducteur/couche mince organique/conducteur, classiquement utilisés dans des dispositifs électroniques. De tels dispositifs sont, par exemple, des diodes redresseuses de courant, des cellules solaires, des cellules photodétectrices, des capacités, des diodes laser, des dispositifs types capteurs, des mémoires, ou encore des diodes électroluminescentes. Il s'agit notamment de dispositifs de l'électronique organique sur substrat plastique souple.

L'invention s'applique plus particulièrement au domaine du photovoltaïque organique, souvent désignée par son acronyme anglais OPV pour « Organic PhotoVoltaic ». Un dispositif photovoltaïque est un dispositif propre à convertir de l'énergie solaire reçue en énergie électrique. La problématique du rendement du dispositif est une problématique récurrente. Aussi, il est souhaitable d'augmenter le plus possible le rendement d'un tel dispositif, c'est-à-dire le ratio entre la puissance électrique produite par le dispositif et l'énergie solaire captée par le dispositif.

Un dispositif photovoltaïque organique comporte au moins une cellule photovoltaïque organique. Un module photovoltaïque organique est un ensemble comprenant au moins deux cellules photovoltaïques.

Chaque cellule est obtenue par le dépôt de plusieurs couches dont au moins la couche active est composée de molécules organiques. De ce fait, l'effet photovoltaïque est obtenu à l'aide des propriétés de matériaux semi-conducteurs organiques.

Les matériaux semi-conducteurs organiques sont solubles dans les solvants organiques et permettent de réaliser le dépôt de couches par technique d'enduction ou d'impression sur des substrats flexibles. Ces méthodes de fabrication sont compatibles avec la production à grande échelle réalisée grâce à des procédés continus tels que les procédés au déroulé plus connus sous le nom anglais de roll-to-roll (noté R2R dans la suite de la description).

En outre, les modules photovoltaïques organiques présentent une épaisseur relativement faible. Il est entendu par une épaisseur relativement faible une épaisseur inférieure ou égale à 500 microns. Cela permet aux modules de disposer d'un générateur d'énergie de très faible épaisseur.

La légèreté, la souplesse mécanique et la semi-transparence des modules photovoltaïques organiques ouvrent des possibilités d'intégration de la technologie photovoltaïque à des champs d'applications inédits pour des applications mobiles ou incluant des surfaces courbes (automobile, électronique portable, tente...).

Cependant envisager le déploiement de cette nouvelle génération de module photovoltaïque sur de nouveaux marchés implique de pouvoir garantir certaines caractéristiques du module, notamment la performance de conversion de la lumière en électricité et la durée de vie des dispositifs.

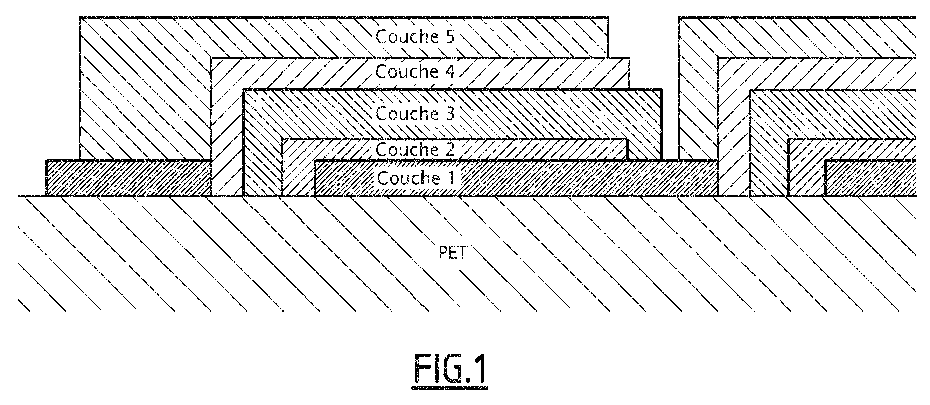

Un dispositif photovoltaïque organique est notamment illustré par la figure 1. Sur cette figure, sont superposées cinq couches, nommées :
- couche 1 représentant une première électrode constituée d'un matériau conducteur ;
- couche 3 représentant une couche active constituée d'au moins un matériau qui est de nature semi-conducteur avantageusement constituée d'un mélange d'un matériau donneur d'électrons (dit matériau de type n) et d'un matériau accepteur d'électrons (dit matériau de type p). De tels matériaux semi-conducteurs peuvent être une molécule, un oligomère ou un polymère organique conjugué. Ainsi, la couche active peut être une hétérojonction d'un matériau donneur d'électrons et d'un matériau accepteur d'électrons se présentant sous la forme d'une couche ou d'un empilement de plusieurs couches. Il peut également s'agir d'un mélange à l'échelle nanométrique des deux matériaux sous la forme d'hétérojonction en volume, c'est-à-dire d'un mélange intime des deux matériaux à l'échelle nanométrique ;
- couche 2 et couche 4 représentant des couches d'interfaces constituées de matériaux présentant le bon type de transport (n ou p) pour remplir leur rôle de transport (ou d'injection) d'électron ou de trous, et
- couche 5 une deuxième électrode constituée d'une couche métallique.

Les cinq couches reposent sur un substrat flexible en matière plastique, par exemple du type PET (poly(téréphtalate d'éthylène), plus connu sous le nom anglais de polyethylene terephthalate (parfois francisé de manière impropre en « polyéthylène téréphtalate ») ou PEN (poly(naphtalate d'éthylène ou polyéthylène naphtalate).

Les matériaux utilisés dans les cellules OPV, tels que les polymères conjugués, sont connus pour être instables à l'air ambiant et particulièrement sensibles à la dégradation induite par l'oxygène et l'humidité (voir notamment l'article de Morgado, J., R. H. Friend, and F. Cacialli. "Environmental aging of poly (p-phenylenevinylene) based light-emitting diodes." Synthetic metals 114.2 (2000): 189-196 et l'article de Sutherland, D. G. J., et al. "Photo-oxidation of electroluminescent polymers studied by core-level photoabsorption spectroscopy." Applied physics letters 68.15 (1996): 2046-2048).

Le squelette conjugué des polymères semi-conducteurs photoactifs combiné à l'introduction de chaînes latérales permettant la solubilisation de ces produits, est très instable. Ce caractère instable est notamment montré dans l'article de Manceau M et al, "Photochemical stability of π-conjugated polymers for polymer solar cells: a rule of thumb". J. Mater. Chem., (2011), 21, 4132.

Dans l'article de Norrman, Kion, et al. "Degradation patterns in water and oxygen of an inverted polymer solar cell." Journal of the American Chemical Society 132.47 (2010): 16883-16892, il a été prouvé que sous irradiation lumineuse, les polymères semi-conducteurs se dégradent. Dans une première étape, les chaînes latérales sont oxydées, initiant une réaction chaîne qui conduit à la dégradation de la structure même du polymère. Cela modifie les propriétés optiques et conductrices des matériaux photosensibles et impacte les rendements des dispositifs.

Dans l'article de Tournebize A. et al. "Is there a photostable conjugated polymer for efficient solar cells?" Polymer Degradation and Stability 112 (2015): 175-184, il est aussi décrit que l'eau peut affecter l'interface entre les électrodes métalliques et les couches de semi-conducteurs organiques par un processus électrochimique provoquant la délamination de l'électrode.

Ces phénomènes de dégradation des dispositifs OPV peuvent être induits par des causes intrinsèques (instabilité des matériaux, interaction chimique aux interfaces, résidus solvantaires, délamination...) ou extrinsèques (diffusion d'oxygène ou d'humidité à travers l'encapsulation, problème de filtration des rayons ultra- violets (UV), écrasement des couches, interaction chimique avec la colle...). Cela est notamment décrit dans l'article Grossiord, Nadia, et al. "Dégradation mechanisms in organic photovoltaic devices." Organic Electronics 13.3 (2012): 432-456.

Il est primordial d'assurer la stabilité extrinsèque des modules OPV directement liée à la qualité de l'encapsulation mais également aux conditions d'utilisation. Le choix des matériaux (film barrière, adhésifs, connectiques) et du design d'encapsulation sont déterminants pour les performances des modules dans le temps.Les problématiques de vieillissement spécifiques au photovoltaïque organique imposent donc une encapsulation des modules immédiatement après enduction. Les dispositifs photovoltaïques organiques sont encapsulés entre des matériaux ou films ultra-barrières les protégeant de l'intrusion de l'oxygène et de l'humidité.

Les films barrières disponibles sont généralement constitués d'un empilement de films polyester et de couches d'oxyde métallique (oxyde d'alumine en général) assurant l'isolation et la protection contre les intrusions d'oxygène et d'humidité. Ces films barrières sont notamment caractérisés par les paramètres de perméabilité du film à l'eau (usuellement noté WVTR pour Water Vapor Transmission Rate) et de perméabilité à l'oxygène (usuellement noté OTR pour Oxygen Transmission Rate). L'adhésion entre les films barrières et le dispositif photovoltaïque est assuré par un adhésif de types adhésifs sensibles à la pression (PSA=pressure sensitive adhesive), colles réticulables via les UV, ou films thermoplastiques.

Le courant électrique généré par un module OPV transite vers des bandes conductrices métalliques ou collecteurs de courant (jusqu'à 0,2 mm en épaisseur et 10 mm de large) qui sont déposés sur les électrodes métalliques enduites des cellules périphériques du module. Le module et ces collecteurs de courant sont inclus dans l'encapsulation afin d'étanchéifier le module.

La nécessaire étanchéité du dispositif ne permet pas de fabriquer des modules dont les collecteurs de courant seraient accessibles à l'extérieur du module comme c'est le cas dans la fabrication des modules photovoltaïques en silicium ou couches-minces Les collecteurs de courant sont donc posés sur les électrodes et encapsulés et scellés pour former le dispositif final. De ce fait, il convient de disposer d'un procédé permettant de reprendre le contact au niveau des collecteurs de courant pour alimenter une application ou une batterie.

Les dispositifs de connexion des modules photovoltaïques existants appelés boitier de jonction assurent la connexion électrique entre les collecteurs de courant du module photovoltaïque et un fil électrique externe. Traditionnellement la connexion établie par le boitier et le collecteur de courant se fait au moyen d'une languette. Le brevet US 7705234 B2 décrit un boitier de jonction positionné sur un module solaire et comportant une languette métallique appliquée dynamiquement directement sur une électrode exposée à l'air du module solaire et reliant le module à un câble électrique.

Ces ouvertures pour créer une zone de reprise de contact créent des zones d'exposition à l'oxygène et à l'humidité accélérant le vieillissement du module et annulant les effets des dispositions prises pour encapsuler hermétiquement le module OPV.

Il existe donc un besoin pour un procédé permettant d'obtenir un dispositif électrique flexible, notamment un dispositif photovoltaïque organique connecté électriquement, présentant un meilleur rendement et une durée de vie plus longue.

Pour cela, la présente description porte notamment sur un procédé de raccordement d'un dispositif électronique organique flexible à un fil électrique, le procédé comportant une étape de fourniture d'un dispositif électronique flexible. Le dispositif comprend un module flexible comprenant une électrode, une bande conductrice déposée sur l'électrode, et un film barrière d'encapsulation encapsulant le module, fourniture d'un fil électrique. Le procédé comprend des étapes de fourniture d'un organe de contact comportant au moins un élément conducteur comprenant une face de contact, la face de contact définissant une surface de contact, la surface de contact présentant une dimension maximale et une dimension minimale, d'incision du film barrière d'encapsulation définissant une surface d'incision, la surface d'incision présentant une dimension maximale et une dimension minimale, la dimension maximale de la surface d'incision étant strictement inférieure à la dimension maximale de la surface de contact, et d'assemblage de l'élément conducteur et de la bande conductrice à travers l'incision pour assurer une conduction électronique entre l'élément conducteur et l'électrode.

La présente invention concerne un nouveau procédé pour raccorder un dispositif organique flexible à une connectique filaire. Ce procédé vise à améliorer l'état de la technique en :
- réduisant au maximum l'exposition des matériaux organiques constitutifs des dispositifs à l'intrusion d'air et d'humidité ;
- contribuant à la stabilité des performances de conversion de l'énergie lumineuse ;
- améliorant la durée de vie des dispositifs ;
- disposant de connectique légère et peu volumineuse préservant les caractéristiques de légèreté et souplesse mécanique des dispositifs.

Suivant des modes de réalisation particuliers, le procédé comprend une ou plusieurs des caractéristiques suivantes, prise(s) isolément ou suivant toutes les combinaisons techniquement possibles :
- le procédé comporte une étape d'enduction d'au moins une partie de la face de contact d'un élément métallique solidifiant à la chaleur pour assurer une soudure, l'étape d'assemblage est mise en oeuvre par chauffage de la face de contact.
- le rapport entre la dimension maximale de la surface d'incision et la dimension minimale de la surface de contact est compris entre 0,9 et 1,2.
- le rapport entre la dimension maximale de la surface d'incision et la dimension minimale de la surface de contact est strictement inférieur à 1,0.
- le rapport entre la dimension minimale de la surface d'incision et la dimension minimale de la surface de contact est strictement inférieur à 1,0.
- le rapport entre la dimension minimale de la surface d'incision et la dimension maximale de la surface de contact est strictement inférieur à 0,25.
- l'élément conducteur comporte une lame d'insertion supportant la face de contact, la lame d'insertion présentant une épaisseur, le rapport entre la dimension minimale de la surface d'incision et l'épaisseur de la lame d'insertion est compris 0,9 et 1,2.
- le rapport entre la dimension minimale de la surface d'incision et l'épaisseur de la lame d'insertion est strictement inférieur à 1,0.
- l'élément conducteur comporte une lame d'insertion supportant la face de contact et une lame de support, l'angle entre la lame de support et la lame d'insertion étant supérieur ou égal à 80°.
- chaque élément conducteur est réalisé en un matériau conducteur.

La présente description décrit aussi un dispositif électronique organique flexible comprenant un module flexible comprenant une électrode, une bande conductrice déposée sur l'électrode, un film barrière d'encapsulation encapsulant le module, le film barrière d'encapsulation comportant une incision définissant une surface d'incision, la surface d'incision présentant une dimension maximale et une dimension minimale, un fil électrique, un organe de contact comportant au moins un élément conducteur comprenant une face de contact, la face de contact définissant une surface de contact, la surface de contact présentant une dimension maximale et une dimension minimale, la dimension maximale de la surface d'incision étant strictement inférieure à la dimension maximale de la surface de contact, l'élément conducteur étant assemblé à la bande conductrice à travers l'incision pour assurer une conduction électronique entre l'élément conducteur et l'électrode.

Suivant un mode de réalisation particulier, le dispositif est un dispositif photovoltaïque.

D'autres caractéristiques et avantages de l'invention apparaîtront à la lecture de la description qui suit de modes de réalisation de l'invention, donnés à titre d'exemple uniquement et en référence aux dessins qui sont :
- figure 1, une vue en coupe d'un module photovoltaïque organique,
- figure 2, un schéma d'un exemple de dispositif photovoltaïque organique,
- figure 3, un schéma d'une partie du dispositif photovoltaïque organique de la figure 2, la partie permettant de définir en particulier une surface d'incision et une surface de contact,
- figure 4, un schéma illustrant la surface d'incision par rapport à la surface de contact selon un premier exemple,
- figure 5, un schéma illustrant la surface d'incision par rapport à la surface de contact selon un deuxième exemple, et
- figure 6, un schéma illustrant la surface d'incision par rapport à la surface de contact selon un troisième exemple.

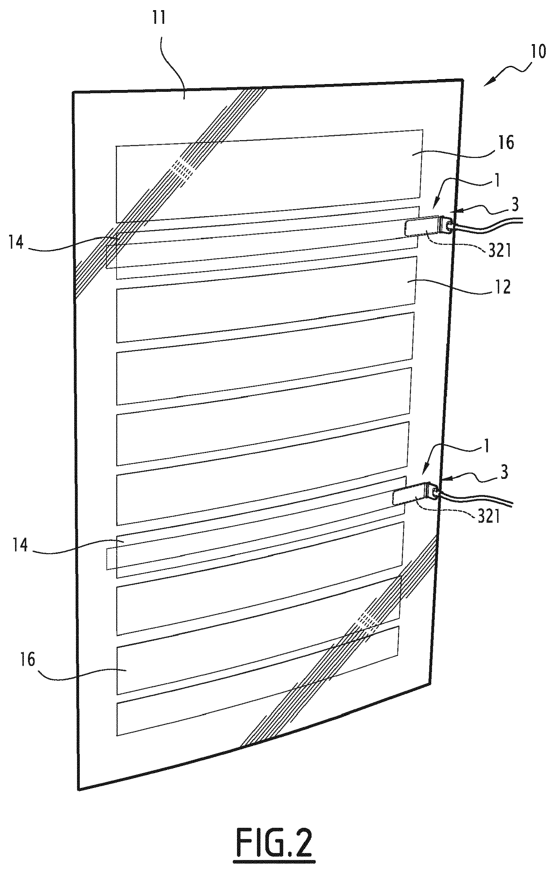

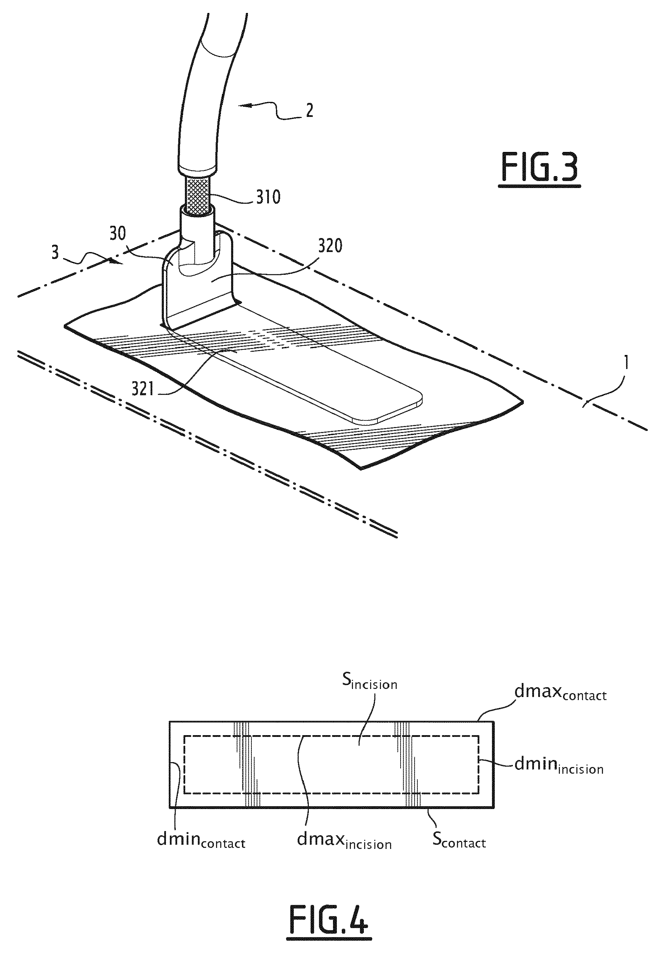

Un dispositif photovoltaïque de type organique est représenté à la figure 2, une partie du dispositif photovoltaïque étant détaillée sur la figure 3.

Un dispositif photovoltaïque est un convertisseur d'énergie solaire en énergie électrique.

Un dispositif photovoltaïque est qualifié d'organique lorsque le matériau actif du dispositif photovoltaïque est organique. Un matériau est considéré comme organique dès lors que le semi-conducteur comprend au moins une liaison faisant partie du groupe constitué par les liaisons covalentes entre un atome de carbone et un atome d'hydrogène, les liaisons covalentes entre un atome de carbone et un atome d'azote, ou encore des liaisons entre un atome de carbone et un atome d'oxygène.

Le dispositif photovoltaïque est un dispositif électronique flexible.

Le dispositif photovoltaïque 10 présenté à la figure 2 se présente sous la forme d'une feuille 11 comportant plusieurs bandes alignées 12, 14, 16. Il ne semble pas nécessaire de décrire plus précisément la figure 2, l'invention étant plus spécifiquement illustrée par la figure 3 détaillée dans ce qui suit.

Le dispositif photovoltaïque comporte un module flexible, une bande conductrice 1, un film barrière d'encapsulation, un fil électrique 2 et un organe de contact 3.

Le module flexible comporte une électrode.

La bande conductrice 1 est déposée sur l'électrode.

Le film barrière d'encapsulation encapsule le module.

Le film barrière est le plus souvent encollé avec des colles auto-adhésives (type PSA) ou UV.

En variante, le film d'encapsulation est dépourvu de colle.

Le film barrière d'encapsulation comportant une incision.

L'incision définit une surface d'incision S_{incision}.

La surface d'incision S_{incision} présente une dimension maximale dmax_{incision} et une dimension minimale dmin_{incision}.

Le fil électrique 2 est destiné à conduire l'électricité.

L'organe de contact 3 comporte au moins un élément conducteur 30.

L'élément de contact 321 a, selon l'exemple de la figure 2, une forme parallélépipédique.

L'élément conducteur 30 est assemblé à la bande conductrice 1 à travers l'incision pour assurer une conduction électronique entre l'élément conducteur 30 et l'électrode.

De préférence, chaque élément conducteur 30 est réalisé en un matériau conducteur.

L'élément conducteur 30 comprend une face de contact 321.

La face de contact 321 définit une surface de contact S_{cornact}.

En l'occurrence, la forme de la surface de contact S_{contact} est de forme rectangulaire.

La surface de contact S_{contact} présente une dimension maximale dmax_{contact} et une dimension minimale dmin_{contact}.

Dans le cas illustré, la dimension maximale dmax_{contact} correspond à la longueur de la surface de contact S_{contact} et la dimension minimale dmin_{contact} correspond à la largeur de la surface de contact S_{contact}.

La dimension maximale dmax_{incision} de la surface d'incision S_{incision} est strictement inférieure à la dimension maximale dmax_{icontact} de la surface de contact S_{contact}.

Un tel dispositif photovoltaïque est obtenu par mise en oeuvre d'un procédé de raccordement d'un dispositif électronique flexible à un fil électrique, ce procédé étant décrit dans ce qui suit.

Le procédé comprend une première étape de fourniture d'un dispositif électronique flexible.

Le dispositif comporte le module flexible, la bande conductrice et le film barrière d'encapsulation.

Le procédé comporte ensuite une deuxième étape de fourniture du fil électrique 2.

Le procédé comporte alors une troisième étape de fourniture de l'organe de contact 3.

Le procédé comprend ensuite une étape d'incision du film barrière d'encapsulation, l'incision définissant une surface d'incision S_{incision}.

L'étape d'incision est mise en oeuvre de sorte que la dimension maximale dmax_{incision} de la surface d'incision S_{incision} soit strictement inférieure à la dimension maximale dmax_{contact} de la surface de contact S_{contact}.

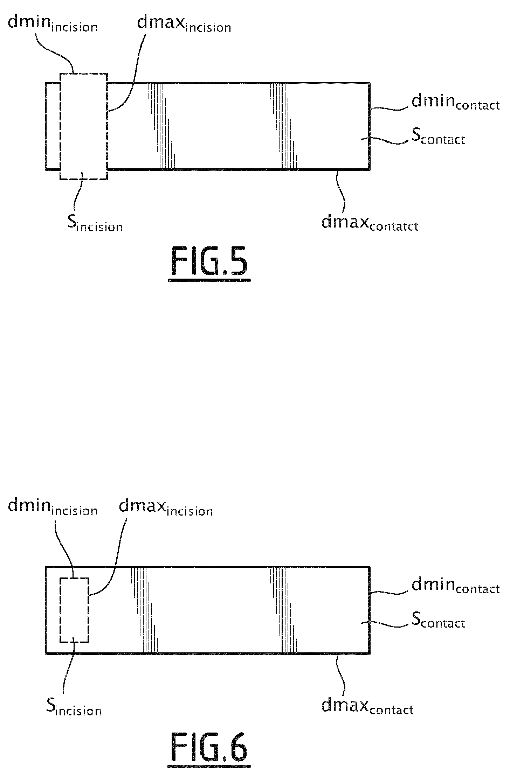

Les figures 4 à 6 montrent différents mode de réalisation pour mettre en oeuvre l'étape d'incision. Les différents modes de réalisation envisageables sont représentés schématiquement en vue de haut dans ce qui suit. Le rectangle en trait plein représente la surface de contact tandis que le trait pointillé représente la surface d'incision.

Selon un premier mode de réalisation, le rapport entre la dimension minimale dmin_{incision} de la surface d'incision S_{incision} et la dimension minimale dmin_{contact} de la surface de contact S_{contact} est strictement inférieur à 1,0.

Plus précisément, la surface d'incision S_{incision} est strictement incluse dans la surface de contact S_{contact}.

Dans ce mode de réalisation, on vient soulever deux côtés de l'incision pour insérer l'organe de contact 30.

Selon un deuxième mode de réalisation, le rapport entre la dimension minimale dmin_{incision} de la surface d'incision S_{incision} et la dimension maximale dmax_{contact} de la surface de contact S_{contact} est strictement inférieur à 0,25.

Par ailleurs, selon le deuxième mode de réalisation, le rapport entre la dimension maximale dmax_{incision} de la surface d'incision S_{incision} et la dimension minimale dmin_{contact} de la surface de contact S_{contact} est compris entre 0,9 et 1,2.

Dans ce mode de réalisation, on vient insérer l'organe de contact 30 dans l'incision.

Selon un troisième mode de réalisation, le rapport entre la dimension minimale dmin_{incision} de la surface d'incision S_{incision} et la dimension maximale dmax_{contact} de la surface de contact S_{contact} est strictement inférieur à 0,25.

Par ailleurs, le rapport entre la dimension minimale dmin_{ncision} de la surface d'incision S_{incision} et la dimension minimale dmin_{contact} de la surface de contact S_{contact} est strictement inférieur à 1,0.

En outre, le rapport entre la dimension maximale dmax_{incision} de la surface d'incision S_{incision} et la dimension minimale dmin_{contact} de la surface de contact S_{contact} est strictement inférieur à 1,0.

Dans ce mode de réalisation, on vient insérer l'organe de contact 30 dans l'incision.

Le procédé comporte également une étape d'assemblage de l'élément conducteur 30 et de la bande conductrice 1 à travers l'incision pour assurer une conduction électronique entre l'élément conducteur 30 et l'électrode.

Selon un mode de réalisation, le procédé comporte une étape d'enduction d'au moins une partie de la face de contact 321 d'un élément métallique solidifiant à la chaleur pour assurer une soudure.

Dans un tel mode de réalisation, l'étape d'assemblage est mise en oeuvre par chauffage de la face de contact 321.

Le dispositif obtenu présente un meilleur rendement du fait de la qualité de l'assemblage obtenu.

De fait, le procédé proposé réduit au maximum l'exposition des couches actives à l'intrusion d'air et d'humidité.

En outre, le procédé simplifie les étapes de la reprise de contact avec une connexion filaire et permettant l'automatisation de ces étapes.

De plus, le procédé assure une fiabilité de contact élevée.

En outre, le procédé contribué à la stabilité des performances de conversion de l'énergie lumineuse.

En plus, le procédé améliore la durée de vie des modules.

Le procédé permet également de disposer de connectique légère et peu volumineuse préservant les caractéristiques de légèreté et souplesse mécanique des modules.

Pour améliorer ces effets, il est également proposé que l'élément conducteur 30 comporte une lame d'insertion 320 supportant la face de contact 321, la lame d'insertion 320 présentant une épaisseur eᵢₙₛₑᵣₜᵢₒₙ, le rapport entre la dimension minimale dmin_{incision} de la surface d'incision S_{incision} et l'épaisseur eᵢₙₛₑᵣₜᵢₒₙ de la lame d'insertion 320 étant compris 0,9 et 1,2.

De manière préférée, le rapport entre la dimension minimale dmin_{incision} de la surface d'incision S_{incision} et l'épaisseur eᵢₙₛₑᵣₜᵢₒₙ de la lame d'insertion 320 est strictement inférieur à 1,0.

En outre, le procédé est simplifié lorsque l'élément conducteur 30 comporte une lame d'insertion 320 supportant la face de contact 321 et une lame de support 310, l'angle entre la lame de support 310 et la lame d'insertion 320 étant supérieur ou égal à 80°.

Un tel procédé s'applique par extension à tout type de dispositif électronique flexique. Notamment, ce procédé est pertinent pour tout le champ d'application de l'électronique organique (par exemple les oled ou les photodétecteurs).

## Revendications

1. Procédé de raccordement d'un dispositif électronique organique flexible à un fil électrique (2), le procédé comportant les étapes de :
- fourniture d'un dispositif électronique flexible, le dispositif comprenant :
- un module flexible comprenant une électrode,
- une bande conductrice (1) déposée sur l'électrode, et
- un film barrière d'encapsulation encapsulant le module,
- fourniture d'un fil électrique (2),
- fourniture d'un organe de contact (3) comportant au moins un élément conducteur (30) comprenant une face de contact (321), la face de contact (321) définissant une surface de contact (S_{contact}), la surface de contact (S_{contact}) présentant une dimension maximale (dmax_{contact}) et une dimension minimale (dmin_{contact}),
- incision du film barrière d'encapsulation définissant une surface d'incision (S_{incision}), la surface d'incision (S_{incision}) présentant une dimension maximale (dmax_{incision}) et une dimension minimale (dmin_{incision}), la dimension maximale (dmax_{incision}) de la surface d'incision (S_{incision}) étant strictement inférieure à la dimension maximale (dmax_{contact}) de la surface de contact (S_{contact}), et
- assemblage de l'élément conducteur (30) et de la bande conductrice (1) à travers l'incision pour assurer une conduction électronique entre l'élément conducteur (30) et l'électrode.

2. Procédé selon la revendication 1, dans lequel le procédé comporte une étape d'enduction d'au moins une partie de la face de contact (321) d'un élément métallique solidifiant à la chaleur pour assurer une soudure, l'étape d'assemblage est mise en oeuvre par chauffage de la face de contact (321).

3. Procédé selon la revendication 1 ou 2, dans lequel le rapport entre la dimension maximale (dmax_{incision}) de la surface d'incision (S_{incision}) et la dimension minimale (dmin_{contact}) de la surface de contact (S_{contact}) est compris entre 0,9 et 1,2.

4. Procédé selon la revendication 3, dans lequel le rapport entre la dimension maximale (dmax_{incision}) de la surface d'incision (S_{incision}) et la dimension minimale (dmin_{contact}) de la surface de contact (S_{contact}) est strictement inférieur à 1,0.

5. Procédé selon l'une quelconque des revendications 1 à 4, dans lequel le rapport entre la dimension minimale (dmin_{ncision}) de la surface d'incision (S_{incision}) et la dimension minimale (dmin_{contact}) de la surface de contact (S_{contact}) est strictement inférieur à 1,0.

6. Procédé selon l'une quelconque des revendications 1 à 4, dans lequel le rapport entre la dimension minimale (dmin_{incision}) de la surface d'incision (S_{incision}) et la dimension maximale (dmax_{contact}) de la surface de contact (S_{contact}) est strictement inférieur à 0,25.

7. Procédé selon l'une quelconque des revendications 1 à 4, dans lequel l'élément conducteur (30) comporte une lame d'insertion (320) supportant la face de contact (321), la lame d'insertion (320) présentant une épaisseur (eᵢₙₛₑᵣₜᵢₒₙ), le rapport entre la dimension minimale (dmin_{incision}) de la surface d'incision (S_{incision}) et l'épaisseur (eᵢₙₛₑᵣₜᵢₒₙ) de la lame d'insertion (320) est compris 0,9 et 1,2.

8. Procédé selon la revendication 7, dans lequel le rapport entre la dimension minimale (dmin_{incision}) de la surface d'incision (S_{incision}) et l'épaisseur (eᵢₙₛₑᵣₜᵢₒₙ) de la lame d'insertion (320) est strictement inférieur à 1,0.

9. Procédé selon l'une quelconque des revendications 1 à 8, dans laquelle l'élément conducteur (30) comporte une lame d'insertion (320) supportant la face de contact (321) et une lame de support (310), l'angle entre la lame de support (310) et la lame d'insertion (320) étant supérieur ou égal à 80°.

10. Procédé selon l'une quelconque des revendications 1 à 9, dans laquelle chaque élément conducteur (30) est réalisé en un matériau conducteur.

11. Dispositif électronique organique flexible comprenant :
- un module flexible comprenant une électrode,
- une bande conductrice (1) déposée sur l'électrode,
- un film barrière d'encapsulation encapsulant le module, le film barrière d'encapsulation comportant une incision définissant une surface d'incision, la surface d'incision présentant une dimension maximale et une dimension minimale,
- un fil électrique (2),
- un organe de contact (3) comportant au moins un élément conducteur (30) comprenant une face de contact (321), la face de contact (321) définissant une surface de contact (S_{contact}), la surface de contact (S_{contact}) présentant une dimension maximale (dmax_{contact}) et une dimension minimale (dmin_{contact}), la dimension maximale (dmax_{incision}) de la surface d'incision (S_{incision}) étant strictement inférieure à la dimension maximale (dmax_{icontact}) de la surface de contact (S_{contact}), l'élément conducteur (30) étant assemblé à la bande conductrice (1) à travers l'incision pour assurer une conduction électronique entre l'élément conducteur (30) et l'électrode.

12. Dispositif selon la revendication 11, dans lequel le dispositif est un dispositif photovoltaïque.
